# EUROPEAN PATENT APPLICATION

(11) **EP 3 041 049 A1**
(43) Date of publication of application: **06.07.2016**
(21) Application number: 14839426.5
(22) Date of filing: 25.08.2014
(51) Int. Cl.: H01L 27/146, G01T 1/20, G01T 7/00, H01L 21/3205, H01L 21/768, H01L 21/822, H01L 23/522, H01L 27/04, H01L 27/144, H01L 29/786, H01L 31/10, H04N 5/32

(54) **ARRAY SUBSTRATE, RADIATION DETECTOR, AND WIRING SUBSTRATE**

(30) Priority: 30.08.2013 JP 2013179368
(71) Applicant: Kabushiki Kaisha Toshiba, Minato-ku Tokyo 105-8001 (JP); Toshiba Electron Tubes & Devices Co., Ltd., Otawara-shi, Tochigi 324-8550 (JP)
(72) Inventor: TAKIKAWA, Tatsuya, Otawara-shi Tochigi 324-8550 (JP); SHIMBA, Yuichi, Otawara-shi Tochigi 324-8550 (JP)
(74) Representative: Henkel, Breuer & Partner
(86) International application number: PCT/JP2014/072135
(87) International publication number: WO 2015/029938

(57) **Abstract**

According to the embodiment, an array substrate includes a substrate, a plurality of first wirings provided on a surface of the substrate and extending in a first direction, a plurality of second wirings provided on the surface of the substrate and extending in a second direction crossing the first direction, a thin film transistor provided in each of a plurality of regions defined by the plurality of first wirings and the plurality of second wirings, a protective layer covering at least the plurality of first wirings and the plurality of second wirings, and a plurality of connection parts is provided in at least one of a region on the protective layer, a region between the plurality of first wirings and the substrate, and a region between the plurality of second wirings and the substrate, electrically is connected to each of the plurality of first wirings and the plurality of second wirings, and includes a conductive material having higher corrosion resistance than a material of the plurality of first wirings and the plurality of second wirings.

An end surface of the plurality of first wirings and the plurality of second wirings on peripheral side of the substrate is covered with the protective layer, and an end surface of the connection part on the peripheral side of the substrate is located at a periphery of the substrate in plan view.

## Description

### [Technical Field]

Embodiments of the invention relates to an array substrate, a radiation detector, and a wiring substrate.

### [Background Art]

A wiring substrate may be provided with circuit elements less resistant to static electricity. For instance, semiconductor elements such as TFT (thin film transistor) and MOSFET (metal-oxide-semiconductor field-effect transistor), and photoelectric conversion elements such as photodiodes are generally less resistant to static electricity. Thus, manufacturing a wiring substrate provided with e.g. circuit elements less resistant to static electricity requires dissipating static electricity generated during the manufacturing process. For instance, an outer short ring is provided around the region provided with the circuit elements so that the static electricity generated during the manufacturing process is discharged through the outer short ring.

The array substrate is an example of the wiring substrate provided with a large number of circuit elements.

For instance, the array substrate provided in a flat panel display includes a large number of thin film transistors.

The array substrate provided in a radiation detector includes a large number of thin film transistors and a large number of photodiodes.

An outer short ring surrounding the region provided with the thin film transistors and the photodiodes is used also when manufacturing such an array substrate.

Here, the outer short ring is needed when manufacturing a wiring substrate or array substrate. However, the outer short ring cannot be left in the finished wiring substrate or array substrate.

Thus, the outer short ring is cut off during the manufacturing process.

After the outer short ring is cut off, the end surface of the conductive member such as the wiring and the electrode connected to the outer short ring is exposed at the cutting surface, i.e., the periphery of the substrate.

In general, the conductive member is formed from a low-resistance metal such as aluminum and chromium. Thus, corrosion occurs when the current flows. The progress of corrosion may result in a line defect. In particular, involvement of water facilitates the progress of corrosion reaction. For instance, a line defect due to corrosion is more likely to occur in dew-condensing environment.

Furthermore, the material of the conductive member may be ionized by corrosion and attached to the exposed end surface of the conductive member. If the ionized material is attached to the end surface of the conductive member, leakage may occur between the adjacent conductive members.

In this case, corrosion can be suppressed by controlling the temperature and humidity of the environment. However, this incurs upsizing of the device and increase of cost.

### [Citation List]

### [Patent Literature]

[Patent Literature 1] JP2012-156204 A (Kokai)
[Patent Literature 2] JP2009-170768 A (Kokai)
[Patent Literature 3] JP05-27263 A (Kokai)

### [Summary of Invention]

### [Technical Problem]

The problem to be solved by the invention is to provide an array substrate, a radiation detector, and a wiring substrate capable of suppressing corrosion at the periphery of the substrate.

### [Solution to Problem]

According to the embodiment, an array substrate includes a substrate, a plurality of first wirings provided on a surface of the substrate and extending in a first direction, a plurality of second wirings provided on the surface of the substrate and extending in a second direction crossing the first direction, a thin film transistor provided in each of a plurality of regions defined by the plurality of first wirings and the plurality of second wirings, a protective layer covering at least the plurality of first wirings and the plurality of second wirings, and a plurality of connection parts is provided in at least one of a region on the protective layer, a region between the plurality of first wirings and the substrate, and a region between the plurality of second wirings and the substrate, electrically is connected to each of the plurality of first wirings and the plurality of second wirings, and includes a conductive material having higher corrosion resistance than a material of the plurality of first wirings and the plurality of second wirings.

An end surface of the plurality of first wirings and the plurality of second wirings on peripheral side of the substrate is covered with the protective layer, and an end surface of the connection part on the peripheral side of the substrate is located at a periphery of the substrate in plan view.

### [Brief Description of Drawings]

[FIG.1]

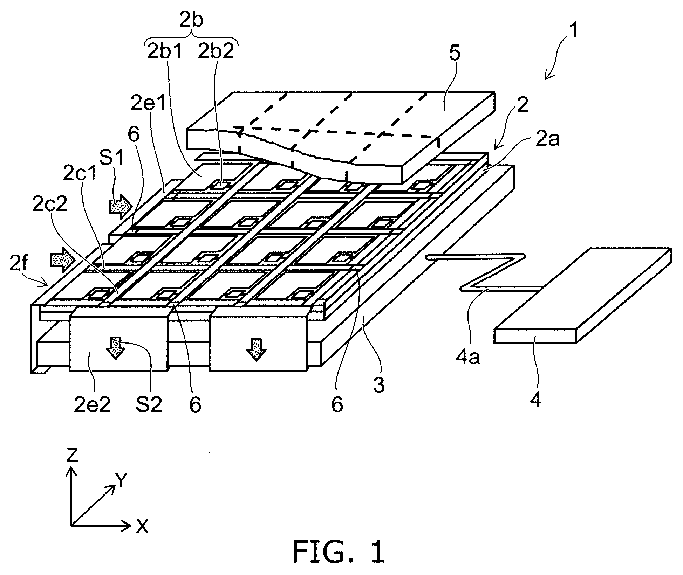

   FIG. 1 is a schematic perspective view for illustrating the X-ray detector 1 according to this embodiment.
[FIG.2]

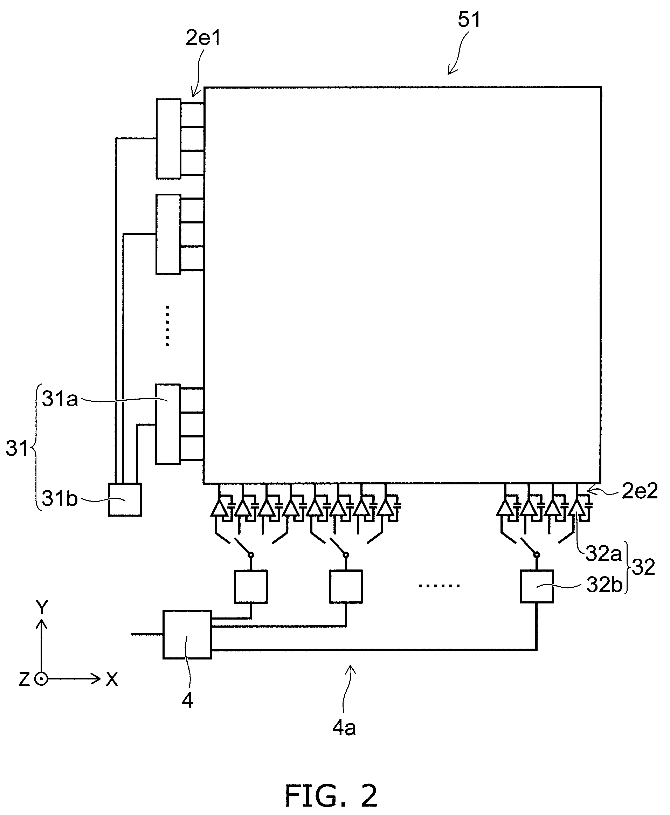

   FIG. 2 is a block diagram of the X-ray detector 1.
[FIG.3]

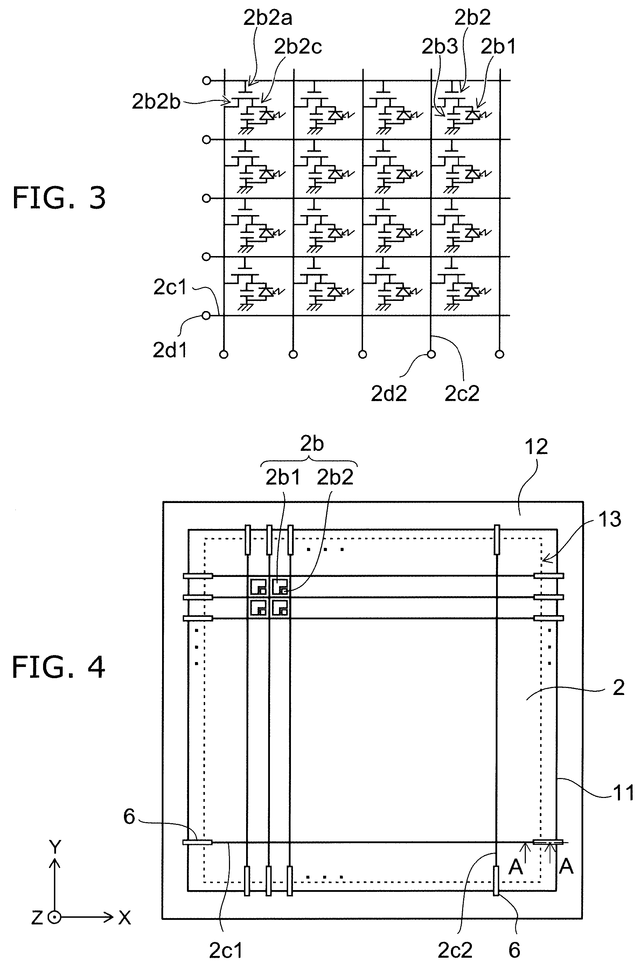

   FIG. 3 is a circuit diagram of the X-ray detector 1.
[FIG.4]
   FIG. 4 is a schematic plan view for illustrating the outer short ring 11.
[FIG.5]

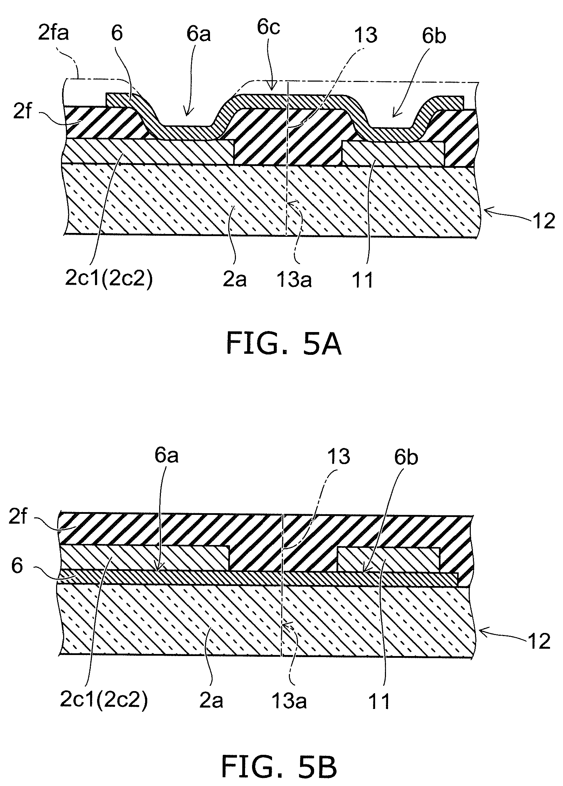

   FIGS. 5A and 5B are schematic sectional views for illustrating the connection part 6.
[FIG.6]

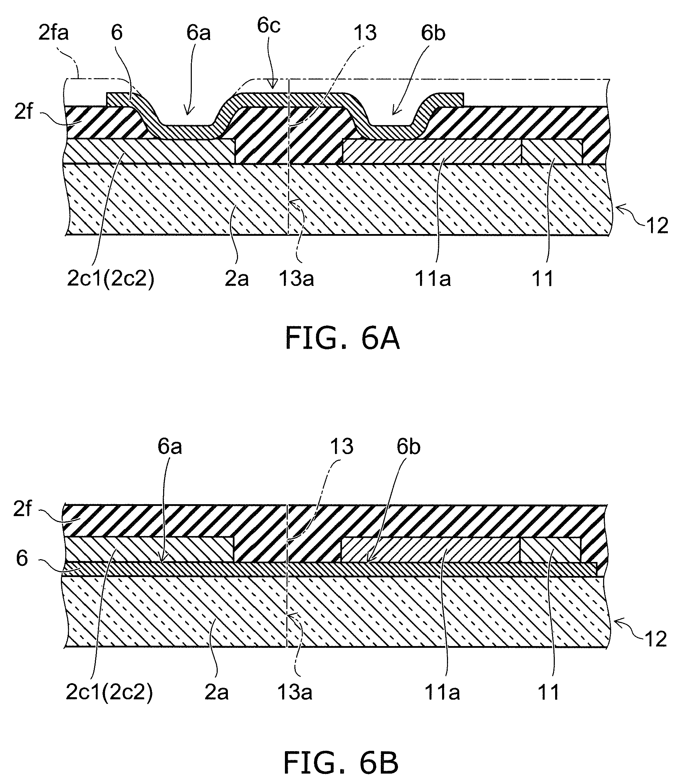

   FIGS. 6A and 6B are schematic sectional views for illustrating an alternative connection mode of the connection part 6.

### [Description of Embodiments]

Various embodiments will be described hereinafter with reference to the accompanying drawings. In the respective drawings, the same components are labeled with like reference numerals, and detailed description thereof is omitted as appropriate.

The wiring substrate according to the embodiment of the invention can be e.g. a plate-like substrate including a wiring pattern thereon. Circuit elements such as semiconductor elements are electrically connected to the wiring pattern.

The array substrate is an example of such a wiring substrate. The array substrate can be e.g. a plate-like substrate including a wiring pattern thereon. Circuit elements such as thin film transistors and photodiodes are electrically connected to the wiring pattern. Such an array substrate is used in e.g. a flat panel display and a radiation detector.

By way of example, the embodiment is described with reference to a radiation detector and an array substrate, which is a wiring substrate used in a radiation detector.

The radiation detector according to this embodiment is applicable to various types of radiation such as γ-rays besides X-rays. By way of example, the embodiment is described with reference to X-rays as a representative of radiation. Thus, the following embodiment is applicable also to other radiation by replacing the term "X-ray" with "other radiation".

The X-ray detector 1 illustrated below is a flat X-ray sensor for detecting an X-ray image, which is a radiation image. Flat X-ray sensors are broadly classified into the direct conversion type and the indirect conversion type.

In the direct conversion type, the photoconductive charge (signal charge) generated inside the photoconductive film in response to incident X-rays is directly led to the accumulation capacitor for charge accumulation by high electric field.

In the indirect conversion type, X-rays are converted to fluorescence (visible light) by a scintillator. The fluorescence is converted to signal charge by a photoelectric conversion element such as a photodiode. The signal charge is led to an accumulation capacitor.

As an example, the following embodiment is illustrated with reference to the case of including an X-ray detector 1 of the indirect conversion type. However, the embodiment is applicable also to the case of including an X-ray detector of the direct conversion type.

The X-ray detector 1 as a radiation detector can be used for e.g. general medical purposes. However, the X-ray detector 1 is not limited to a particular purpose as long as including a radiation detection part (X-ray detection part).

FIG. 1 is a schematic perspective view for illustrating the X-ray detector 1 according to this embodiment.

FIG. 2 is a block diagram of the X-ray detector 1.

FIG. 3 is a circuit diagram of the X-ray detector 1.

As shown in FIG. 1, the X-ray detector 1 includes an array substrate 2, a signal processing part 3, an image transmission part 4, and a scintillator 5.

The array substrate 2 converts fluorescence (visible light) to an electrical signal. The fluorescence is converted from X-rays by the scintillator 5.

The array substrate 2 includes a substrate 2a, a photoelectric conversion part 2b, a control line (or gate line) 2c1 (corresponding to an example of the first wiring), and a data line (or signal line) 2c2 (corresponding to an example of the second wiring).

The substrate 2a is shaped like a plate and formed from e.g. glass.

The photoelectric conversion part 2b is provided in a plurality on one surface of the substrate 2a.

The photoelectric conversion part 2b has a rectangular shape and provided in each of a plurality of regions defined by a plurality of control lines 2c1 and a plurality of data lines 2c2. The plurality of photoelectric conversion parts 2b are arranged in a matrix.

One photoelectric conversion part 2b corresponds to one pixel.

Each of the plurality of photoelectric conversion parts 2b includes a photoelectric conversion element 2b1, and a thin film transistor (TFT) 2b2 as a switching element.

As shown in FIG. 3, an accumulation capacitor 2b3 for accumulating signal charge converted in the photoelectric conversion element 2b1 can be provided. The accumulation capacitor 2b3 is shaped like e.g. a rectangular plate. The accumulation capacitor 2b3 can be provided below each thin film transistor 2b2. However, depending on the capacitance of the photoelectric conversion element 2b1, the photoelectric conversion element 2b1 can double as an accumulation capacitor 2b3.

The photoelectric conversion element 2b1 can be e.g. a photodiode.

The thin film transistor 2b2 performs switching between accumulation and release of charge generated in response to fluorescence incident on the photoelectric conversion element 2b1. The thin film transistor 2b2 can include a semiconductor material such as amorphous silicon (a-Si) and polysilicon (P-Si). The thin film transistor 2b2 includes a gate electrode 2b2a, a source electrode 2b2b, and a drain electrode 2b2c. The gate electrode 2b2a of the thin film transistor 2b2 is electrically connected to the corresponding control line 2c1. The source electrode 2b2b of the thin film transistor 2b2 is electrically connected to the corresponding data line 2c2. The drain electrode 2b2c of the thin film transistor 2b2 is electrically connected to the corresponding photoelectric conversion element 2b1 and accumulation capacitor 2b3.

The control line 2c1 is provided in a plurality. The control lines 2c1 are provided in parallel with a prescribed spacing from each other. The control line 2c1 extends in the X-direction (e.g., row direction) (corresponding to an example of the first direction).

The plurality of control lines 2c1 are electrically connected to a plurality of wiring pads 2d1 provided near the periphery of the substrate 2a, respectively. One end of a plurality of wirings provided on a flexible printed substrate 2e1 is electrically connected to each of the plurality of wiring pads 2d1. The other end of each of the plurality of wirings provided on the flexible printed substrate 2e1 is electrically connected to a control circuit 31 provided in the signal processing part 3.

The data line 2c2 is provided in a plurality. The data lines 2c2 are provided in parallel with a prescribed spacing from each other. The data line 2c2 extends in the Y-direction (e.g., column direction) (corresponding to an example of the second direction) orthogonal to the X-direction.

The plurality of data lines 2c2 are electrically connected to a plurality of wiring pads 2d2 provided near the periphery of the substrate 2a, respectively. One end of a plurality of wirings provided on a flexible printed substrate 2e2 is electrically connected to each of the plurality of wiring pads 2d2. The other end of each of the plurality of wirings provided on the flexible printed substrate 2e2 is electrically connected to an amplification-conversion circuit 32 provided in the signal processing part 3.

The control line 2c1 and the data line 2c2 can be formed from a low-resistance metal such as aluminum and chromium.

Furthermore, a protective layer 2f covering the photoelectric conversion parts 2b, the control lines 2c1, and the data lines 2c2 can be provided (see FIGS. 5A and 5B).

The protective layer 2f includes e.g. at least one of an oxide insulating material, a nitride insulating material, an oxynitride insulating material, and a resin material.

The oxide insulating material is e.g. silicon oxide or aluminum oxide.

The nitride insulating material is e.g. silicon nitride or aluminum nitride.

The oxynitride insulating material is e.g. silicon oxynitride.

The resin material is e.g. acrylic resin.

However, preferably, the resin material is not used on the region including the cut line 13, described later, in the protective layer 2f. This is because cutting a soft material such as a resin material with a cutter wheel may shorten the lifetime of the cutter wheel or degrade the cutting quality such as cutting accuracy.

Thus, the entirety of the protective layer 2f, or the region including the cut line 13 in the protective layer 2f, preferably includes at least one of an oxide insulating material, a nitride insulating material, and an oxynitride insulating material.

That is, the region of the protective layer 2f at least near the periphery of the substrate 2a preferably includes at least one of an oxide insulating material, a nitride insulating material, and an oxynitride insulating material.

The signal processing part 3 is provided on the opposite side of the substrate 2a from the side provided with the photoelectric conversion part 2b.

The signal processing part 3 includes a control circuit 31 and an amplification-conversion circuit 32.

As shown in FIG. 2, the control circuit 31 includes a plurality of gate drivers 31a and a row select circuit 31b.

The gate driver 31a applies a control signal S1 to the corresponding control line 2c1.

In accordance with the scan direction of the X-ray image, the row select circuit 31b sends an external control signal S1 to the corresponding gate driver 31a.

For instance, the control circuit 31 sequentially applies a control signal S1 for each control line 2c1 through the flexible printed substrate 2e1 and the control line 2c1. The control signal S1 applied to the control line 2c1 turns on the thin film transistor 2b2. This enables receiving the signal charge (image data signal S2) from the photoelectric conversion element 2b1.

The amplification-conversion circuit 32 includes a plurality of integral amplifiers 32a and a plurality of A/D converters 32b.

The integral amplifier 32a amplifies the image data signal S2 from each photoelectric conversion element 2b1 through the data line 2c2, the wiring pad 2d2, and the flexible printed substrate 2e2 for output. The image data signal S2 outputted from the integral amplifier 32a is subjected to parallel/serial conversion and inputted to the A/D converter 32b.

The A/D converter 32b converts the inputted image data signal S2 (analog signal) to a digital signal.

The image transmission part 4 is electrically connected to the amplification-conversion circuit 32 of the signal processing part 3 through a wiring 4a. The image transmission part 4 may be integrated with the signal processing part 3.

The image transmission part 4 synthesizes an X-ray image based on the image data signal S2 converted to the digital signal by a plurality of A/D converters 32b. The data of the synthesized X-ray image is outputted from the image transmission part 4 toward external equipment.

The scintillator 5 is provided on the photoelectric conversion element 2b1. The scintillator 5 converts incident X-rays to fluorescence, i.e., visible light. The scintillator 5 is provided so as to cover the region provided with a plurality of photoelectric conversion parts 2b on the substrate 2a.

The scintillator 5 can be formed from e.g. cesium iodide (CsI):thallium (TI) or sodium iodide (NaI):thallium (TI). In this case, a collection of columnar crystals can be formed by e.g. vacuum evaporation technique.

The scintillator 5 can also be formed from e.g. gadolinium oxysulfide (Gd₂O₂S). In this case, for instance, the scintillator 5 can be formed as follows.

First, particles made of gadolinium oxysulfide are mixed with a binder material.

Next, the mixed material is applied onto a substrate made of e.g. carbon-fiber-reinforced plastic (CFRP). This is heat-cured to form a scintillator panel.

Next, a groove part is formed in the heat-cured material using e.g. a cutter wheel. At this time, a matrix-like groove part can be formed so that a scintillator 5 shaped like a quadrangular prism is provided for each of the plurality of photoelectric conversion parts 2b. The groove part can be filled with atmosphere (air), or an antioxidant inert gas such as nitrogen gas. The groove part may be placed in the vacuum state.

In this case, the substrate (scintillator panel) provided with the scintillator 5 is laminated with the array substrate 2 provided with the photoelectric conversion element 2b1.

Besides, it is desired to improve the sensitivity characteristics by enhancing the fluorescence utilization efficiency. To this end, a reflective layer, not shown, can be provided so as to cover the front surface side (the side irradiated with X-rays) of the scintillator 5.

Furthermore, a moisture-proof body, not shown, covering the scintillator 5 and the reflective layer, not shown, can be provided to suppress the degradation of the characteristics of the scintillator 5 and the reflective layer, not shown, due to water vapor contained in the air.

A large amount of X-ray irradiation of the human body may adversely affect the health. Thus, the amount of X-ray irradiation of the human body is held down to the minimum necessary.

Accordingly, the intensity of X-rays incident on the X-ray detector 1 is very weak. Thus, the amount of signal charge outputted from the thin film transistor 2b2 is very small.

The thin film transistor 2b2 used to process such a weak signal easily incurs characteristics change or destruction by static electricity.

In this case, a control line 2c1 and a data line 2c2 are electrically connected to the thin film transistor 2b2.

Thus, an outer short ring 11 electrically connected to all the control lines 2c1 and all the data lines 2c2 is provided when manufacturing the array substrate 2.

The outer short ring 11 can be formed from a low-resistance metal such as aluminum and chromium.

In this case, the control lines 2c1, the data lines 2c2, and the outer short ring 11 can be formed from the same material. Then, the control lines 2c1, the data lines 2c2, and the outer short ring 11 can be formed simultaneously in the same process.

FIG. 4 is a schematic plan view for illustrating the outer short ring 11.

As shown in FIG. 4, the outer short ring 11 is provided around the region provided with a plurality of photoelectric conversion parts 2b. All the control lines 2c1 and all the data lines 2c2 are electrically connected to the outer short ring 11.

Here, as shown in FIG. 3, in the state of being incorporated in the X-ray detector 1, all the control lines 2c1 and all the data lines 2c2 need to be independent of each other.

Thus, first, the outer short ring 11, the control lines 2c1, the data lines 2c2, the photoelectric conversion parts 2b and the like are sequentially formed on a substrate 12 constituting the substrate 2a. Next, the array substrate 2 is manufactured by cutting along the cut line 13 located outside the wiring pads 2d1 and the wiring pads 2d2. The cutting can be performed by e.g. cutting with a cutter wheel or cutting by laser scribing.

However, if the outer short ring 11 is directly connected to the control lines 2c1 and the data lines 2c2, the end surface of the control lines 2c1 and the data lines 2c2 electrically connected to the outer short ring 11 is exposed at the cutting surface. The control line 2c1 and the data line 2c2 are formed from a low-resistance metal such as aluminum and chromium. Thus, corrosion occurs when the current flows. The progress of corrosion may result in a line defect. In particular, involvement of water facilitates the progress of corrosion reaction. For instance, a line defect due to corrosion is more likely to occur in dew-condensing environment.

Furthermore, the material of the control line 2c1 and the data line 2c2 may be ionized by corrosion and attached to the exposed end surface of the control line 2c1 and the data line 2c2. If the ionized material is attached to the end surface of the control line 2c1 and the data line 2c2, leakage may occur between the adjacent control lines 2c1 and between the adjacent data lines 2c2. If leakage occurs, the output fails to be proportional to the amount of X-rays. This may degrade the quality of the X-ray image.

Thus, the array substrate 2 according to this embodiment includes a connection part 6 near the cut line 13. Before cutting along the cut line 13, the control line 2c1 and the data line 2c2 are each electrically connected to the outer short ring 11 through the connection part 6.

FIGS. 5A and 5B are schematic sectional views for illustrating the connection part 6.

FIGS. 5A and 5B show a cross section taken along line A-A in FIG. 4.

As shown in FIG. 5A, the control line 2c1 (data line 2c2) and the outer short ring 11 are provided on the substrate 12 constituting the substrate 2a.

The control line 2c1 (data line 2c2) and the outer short ring 11 are covered with the protective layer 2f.

The protective layer 2f is provided with a hole. The neighborhood of the end part of the control line 2c1 (data line 2c2), and the outer short ring 11 are exposed at the bottom of the hole.

The connection part 6 is shaped like a line and provided on the protective layer 2f. The connection part 6 is electrically connected to the neighborhood of the end part of the control line 2c1 (data line 2c2), and the outer short ring 11 through the hole provided in the protective layer 2f. For instance, the connection part 6 is electrically connected to the control line 2c1 (data line 2c2) in the region 6a. The connection part 6 is electrically connected to the outer short ring 11 in the region 6b.

A protective layer 2fa covering the connection part 6 can be further provided.

In the case of providing the protective layer 2fa, the protective layer 2fa is provided with a hole so that the region 6a is exposed at the bottom of the hole.

The region 6a can be the aforementioned wiring pad 2d1 (wiring pad 2d2).

The region 6c between the region 6a and the region 6b can be a region to be touched with a probe at the time of electrical test. The electrical test is e.g. a test for confirming the presence or absence of anomaly of the photoelectric conversion element 2b1 or anomaly of electrical connection.

At the time of electrical test, the touching probe may leave e.g. a dent in the region 6c. However, the flexible printed substrate 2e1 (flexible printed substrate 2e2) can be electrically connected to the control line 2c1 (data line 2c2) in the region 6a.

Thus, occurrence of e.g. a dent in the region 6c does not affect the function of the array substrate 2.

Alternatively, as shown in FIG. 5B, the connection part 6 can be provided between the control line 2c1 (data line 2c2) and the substrate 12 constituting the substrate 2a.

Then, for instance, the photoelectric conversion parts 2b and the like can be formed in the state in which the control line 2c1 (data line 2c2) is electrically connected to the outer short ring 11. That is, this can provide countermeasures against static electricity in the process for forming the array substrate 2.

Alternatively, the connection part 6 can be provided in both the region on the protective layer 2f and the region between the control line 2c1 (data line 2c2) and the substrate 12 constituting the substrate 2a. That is, the connection part 6 can be provided in a two-layer structure.

Thus, the connection part 6 can be provided in at least one of the region on the protective layer 2f and the region between the control line 2c1 (data line 2c2) and the substrate 12 constituting the substrate 2a.

The connection part 6 includes a conductive material having higher corrosion resistance than the material of the control line 2c1 (data line 2c2).

The connection part 6 includes e.g. at least one of an oxide conductive material and an anticorrosion metal.

The oxide conductive material can be e.g. ITO (indium tin oxide), IZO (indium zinc oxide), ZnO (zinc oxide), Sn₂O₃:Sb, Sn₂O₃:F, or IGZO (indium gallium zinc oxide).

The anticorrosion metal can be e.g. gold (Au).

The end surface of the control line 2c1 (data line 2c2) is provided inside the cut line 13. The end surface of the control line 2c1 (data line 2c2) is covered with the protective layer 2f. That is, the end surface of the control line 2c1 (data line 2c2) does not reach the cut line 13.

Thus, after cutting along the cut line 13, the end surface of the substrate 2a, the end surface of the protective layer 2f, and the end surface of the connection part 6 are exposed at the cutting surface 13a.

That is, the end surface of the plurality of control lines 2c1 and the plurality of data lines 2c2 on the peripheral side of the substrate 2a is covered with the protective layer 2f.

The end surface of the connection part 6 on the peripheral side of the substrate 2a is located at the periphery of the substrate 2a in plan view.

In this case, the substrate 2a is formed from e.g. glass. The protective layer 2f is formed from e.g. an oxide insulating material or a nitride insulating material.

The connection part 6 is formed from e.g. an oxide conductive material or an anticorrosion metal such as gold.

Thus, the component exposed at the cutting surface 13a is formed from a material having high corrosion resistance. This can suppress the occurrence of line defects and leakages due to corrosion.

Here, if the component located at the cut line 13 is formed from a soft material such as resin material and aluminum, then cutting with a cutter wheel or cutting by laser scribing may fail to achieve high accuracy. Furthermore, this may also shorten the lifetime of the cutter wheel.

In this case, the connection part 6 can be formed from an oxide conductive material. Then, a hard material can be used for all the materials of the component located at the cut line 13.

Thus, cutting can be performed with high accuracy. This can improve the yield. Furthermore, this can prolong the lifetime of the cutter wheel.

FIGS. 6A and 6B are schematic sectional views for illustrating an alternative connection mode of the connection part 6.

Depending on the wiring layout on the array substrate 2, the distance between the end surface of the control line 2c1 (data line 2c2) and the outer short ring 11 may be elongated. In this case, if the connection part 6 is formed from an oxide conductive material having high electrical resistance, the electrical resistance between the control line 2c1 (data line 2c2) and the outer short ring 11 may be made too high.

Thus, as shown in FIGS. 6A and 6B, an extension part 11a is provided in this embodiment.

One end of the extension part 11a is electrically connected to the outer short ring 11.

The other end of the extension part 11a is provided near the cut line 13.

The extension part 11a can be formed from a low-resistance metal such as aluminum and chromium. The extension part 11a formed from a low-resistance metal can suppress the increase of electrical resistance even if the distance between the end surface of the control line 2c1 (data line 2c2) and the outer short ring 11 is elongated.

Alternatively, as shown in FIG. 6B, the connection part 6 can be provided between the control line 2c1 (data line 2c2) and the substrate 12 constituting the substrate 2a.

Then, for instance, the photoelectric conversion parts 2b and the like can be formed in the state in which the control line 2c1 (data line 2c2) is electrically connected to the outer short ring 11. That is, this can provide countermeasures against static electricity in the process for forming the array substrate 2.

Alternatively, the connection part 6 can be provided in both the region on the protective layer 2f and the region between the control line 2c1 (data line 2c2) and the substrate 12 constituting the substrate 2a. That is, the connection part 6 can be provided in a two-layer structure.

Thus, the connection part 6 can be provided in at least one of the region on the protective layer 2f and the region between the control line 2c1 (data line 2c2) and the substrate 12 constituting the substrate 2a.

Next, the function of the X-ray detector 1 is illustrated.

First, in the initial state, charge is accumulated in the accumulation capacitor 2b3. A reverse bias voltage is applied to the photoelectric conversion element 2b1 parallel connected to the accumulation capacitor 2b3. The voltage applied to the photoelectric conversion element 2b1 is equal to the voltage applied to the data line 2c2. The photoelectric conversion element 2b1 is e.g. a photodiode, which is a type of diode. Thus, little current flows therein under application of reverse bias voltage. Accordingly, the charge accumulated in the accumulation capacitor 2b3 is held without decrease.

X-rays are incident on the scintillator 5. Then, high-energy X-rays are converted to low-energy fluorescence (visible light) inside the scintillator 5. Part of the fluorescence generated inside the scintillator 5 is incident on the photoelectric conversion element 2b1.

The fluorescence incident on the photoelectric conversion element 2b1 is converted to charge composed of electrons and holes inside the photoelectric conversion element 2b1. The electrons and holes travel along the direction of the electric field formed by the accumulation capacitor 2b3 and reach the opposite terminals of the photoelectric conversion element 2b1, respectively. Thus, a current flows inside the photoelectric conversion element 2b1.

The current flowing inside the photoelectric conversion element 2b1 flows into the parallel connected accumulation capacitor 2b3. The current flowing into the accumulation capacitor 2b3 cancels the charge accumulated in the accumulation capacitor 2b3. This decreases the charge accumulated in the accumulation capacitor 2b3. The potential difference between the opposite terminals of the accumulation capacitor 2b3 also decreases compared with the initial state.

The plurality of control lines 2c1 are electrically connected to the corresponding gate drivers 31a. The gate drivers 31a sequentially change the potential of the plurality of control lines 2c1. That is, the gate drivers 31a sequentially apply a control signal S1 to the plurality of control lines 2c1. In this case, at a particular time, the potential of only one control line 2c1 is changed by the gate drivers 31a. The region between the source electrode 2b2b2 and the drain electrode 2b2c of the thin film transistor 2b2 parallel connected to the data line 2c2 corresponding to the control line 2c1 with the changed potential turns from the off-state (insulating state) to the on-state (conducting state).

A prescribed voltage is applied to each data line 2c2. The voltage applied to the data line 2c2 is applied to the accumulation capacitor 2b3 through the thin film transistor 2b2 electrically connected to the control line 2c1 with the changed potential.

In the initial state, the accumulation capacitor 2b3 is placed at the same potential as the data line 2c2. Thus, no charge is carried from the data line 2c2 to the accumulation capacitor 2b3 when the amount of charge of the accumulation capacitor 2b3 is not changed from the initial state.

On the other hand, the amount of charge is decreased in the accumulation capacitor 2b3 parallel connected to the photoelectric conversion element 2b1 irradiated with fluorescence. That is, the amount of charge of the accumulation capacitor 2b3 parallel connected to the photoelectric conversion element 2b1 irradiated with fluorescence is changed from the initial state. Thus, charge is carried from the data line 2c2 to the accumulation capacitor 2b3 through the thin film transistor 2b2 turned to the on-state. As a result, the amount of charge accumulated in the accumulation capacitor 2b3 returns to the initial state. The carried charge flows in the data line 2c2 and is outputted toward the integral amplifier 32a as an image data signal S2.

The plurality of data lines 2c2 are electrically connected to the corresponding integral amplifiers 32a.

The integral amplifier 32a integrates the current flowing within a given time interval and outputs a voltage corresponding to the integral value. That is, the integral amplifier 32a converts the amount of charge flowing in the data line 2c2 within a given time interval to a voltage value. As a result, the signal charge (image data signal S2) generated inside the photoelectric conversion element 2b1 is converted to potential information by the integral amplifier 32a.

The potential information converted by the integral amplifiers 32a is sequentially converted to a digital signal by the A/D converters 32b. The digitized image data signals S2 are synthesized into an X-ray image by the image transmission part 4. For instance, the image transmission part 4 sequentially synthesizes the digitized image data signals S2 in accordance with the row and column of the pixels to generate an X-ray image. The electrical signal associated with the generated X-ray image is outputted toward external equipment such as a display device, not shown.

The electrical signal associated with the X-ray image outputted toward external equipment can be easily turned to an image by e.g. an ordinary display device. Thus, the X-ray image obtained by X-ray irradiation can be observed as an image of visible light.

The array substrate 2 illustrated above is used in an X-ray detector. Thus, the array substrate 2 includes a photoelectric conversion element 2b1 and a thin film transistor 2b2.

However, the array substrate used in e.g. a flat panel display includes a thin film transistor 2b2.

The wiring substrate comprises a substrate, a wiring provided on the surface of the substrate, a circuit element electrically connected to the wiring, a protective layer covering at least the wiring, and a connection part provided in at least one of the region on the protective layer and the region between the wiring and the substrate, electrically connected to the wiring, and including a conductive material having higher corrosion resistance than the material of the wiring.

In this case, the end surface of the wiring on the peripheral side of the substrate is covered with the protective layer. The end surface of the connection part on the peripheral side of the substrate is located at the periphery of the substrate in plan view.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

### [Reference Signs List]

- 1: X-ray detector
- 2: array substrate
- 2a: substrate
- 2b: photoelectric conversion part
- 2b1: photoelectric conversion element
- 2b2: thin film transistor
- 2b3: accumulation capacitor
- 2c1: control line
- 2c2: data line
- 2f: protective layer
- 3: signal processing part
- 4: image transmission part
- 5: scintillator
- 6: connection part
- 6a-6c: region
- 11: outer short ring
- 11a: extension part
- 12: substrate
- 13: cut line
- 13a: cutting surface
- 31: control circuit
- 32: amplification-conversion circuit

## Claims

1. An array substrate comprising:
a substrate;
a plurality of first wirings provided on a surface of the substrate and extending in a first direction;
a plurality of second wirings provided on the surface of the substrate and extending in a second direction crossing the first direction;
a thin film transistor provided in each of a plurality of regions defined by the plurality of first wirings and the plurality of second wirings;
a protective layer covering at least the plurality of first wirings and the plurality of second wirings; and
a plurality of connection parts provided in at least one of a region on the protective layer, a region between the plurality of first wirings and the substrate, and a region between the plurality of second wirings and the substrate, electrically connected to each of the plurality of first wirings and the plurality of second wirings, and including a conductive material having higher corrosion resistance than a material of the plurality of first wirings and the plurality of second wirings,
an end surface of the plurality of first wirings and the plurality of second wirings on peripheral side of the substrate being covered with the protective layer, and
an end surface of the connection part on the peripheral side of the substrate being located at a periphery of the substrate in plan view.

2. The substrate according to claim 1, wherein the connection part includes at least one of an oxide conductive material and an anticorrosion metal.

3. The substrate according to claim 1 or 2, wherein the connection part includes at least one selected from the group consisting of ITO, IZO, ZnO, Sn₂O₃:Sb, Sn₂O₃:F, IGZO, and gold (Au).

4. The substrate according to claim 1, wherein a region of the protective layer at least near the periphery of the substrate includes at least one of an oxide insulating material, a nitride insulating material, and an oxynitride insulating material.

5. A radiation detector comprising:
the array substrate according to claim 1;
a photoelectric conversion element provided in each of the plurality of regions defined by the plurality of first wirings and the plurality of second wirings of the array substrate; and
a scintillator provided on the photoelectric conversion element.

6. A wiring substrate comprising:
a substrate;
a wiring provided on a surface of the substrate;
a circuit element electrically connected to the wiring;
a protective layer covering at least the wiring; and
a connection part provided in at least one of a region on the protective layer and a region between the wiring and the substrate, electrically connected to the wiring, and including a conductive material having higher corrosion resistance than a material of the wiring,
an end surface of the wiring on peripheral side of the substrate being covered with the protective layer, and
an end surface of the connection part on the peripheral side of the substrate being located at a periphery of the substrate in plan view.

7. The substrate according to claim 6, wherein the connection part includes at least one of an oxide conductive material and an anticorrosion metal.

8. The substrate according to claim 6, wherein the connection part includes at least one selected from the group consisting of ITO, IZO, ZnO, Sn₂O₃:Sb, Sn₂O₃:F, IGZO, and gold (Au).

9. The substrate according to claim 6, wherein a region of the protective layer at least near the periphery of the substrate includes at least one of an oxide insulating material, a nitride insulating material, and an oxynitride insulating material.
